# EUROPEAN PATENT APPLICATION

(11) **EP 4 775 719 A1**
(43) Date of publication of application: **15.07.2026**
(21) Application number: 24862829.9
(22) Date of filing: 04.09.2024
(51) Int. Cl.: C30B 29/04

(54) **METHOD FOR GENERATING GROUP IV-VACANCY CENTER, AND METHOD FOR PRODUCING DIAMOND CRYSTAL HAVING GROUP IV-VACANCY CENTER**

(30) Priority: 04.09.2023 JP 2023143180
(71) Applicant: NATIONAL INSTITUTES FOR QUANTUM SCIENCE AND TECHNOLOGY, Chiba-shi, Chiba 263-8555 (JP); National Institute for Materials Science, Tsukuba-shi, Ibaraki 305-0047 (JP)
(72) Inventor: ONODA, Shinobu, Chiba-shi, Chiba 263-8555 (JP); BABA, Tomoya, Chiba-shi, Chiba 263-8555 (JP); KIMURA, Kosuke, Chiba-shi, Chiba 263-8555 (JP); IIZAWA, Masatomi, Chiba-shi, Chiba 263-8555 (JP); KADA, Wataru, Chiba-shi, Chiba 263-8555 (JP); MIYAKAWA, Masashi, Tsukuba-shi, Ibaraki 305-0047 (JP)
(74) Representative: Algemeen Octrooi- en Merkenbureau B.V.
(86) International application number: PCT/JP2024/031723
(87) International publication number: WO 2025/053177

(57) **Abstract**

To realize a production method for the formation of a group IV-vacancy center(s), the method achieving improved efficiency in the formation of the group IV-vacancy center(s), a generation method is a method for generating a group IV-vacancy (V) center(s) and includes: a preparation step (S11) of preparing a diamond containing a group IV element(s) and vacancies; and a rapid thermal annealing step (S12) of subjecting the diamond to rapid thermal annealing at a target temperature of not lower than 800°C to form a group IV-vacancy center(s) in the diamond.

## Description

### Technical Field

The present invention relates to a method for generating a group IV-vacancy center(s) and a method for producing a diamond crystal having a group IV-vacancy center(s).

### Background Art

A color center(s) is/are expected to be applied to various devices (for example, quantum information devices and quantum sensors). Thus, a technique for efficiently producing a material having a color center(s) (hereinafter referred to as a "color center material") (technique for efficiently generating a color center(s)) has been developed (Patent Literature 1 and Non-patent Literatures 1 to 3). Examples of the color center(s) include(s) a nitrogen-vacancy (NV) center(s) having a nitrogen element and a group IV-vacancy (V) center(s) having a group IV element(s) (in the new IUPAC notation, a group 14 element(s); for example, silicon, germanium, and tin).

### Citation List

### [Patent Literature]

### [Patent Literature 1]

U.S. Patent Application Publication No. 2021/0371741 A1

### [Non-patent Literature]

### [Non-patent Literature 1]

T. Yamamoto, et al., "Extending spin coherence times of diamond qubits by high-temperature annealing", PHYSICAL REVIEW B 88, 075206(2013)

### [Non-patent Literature 2]

Sorawis Sangtawesin, et al., "Origins of Diamond Surface Noise Probed by Correlating Single-Spin Measurements with Surface Spectroscopy", PHYSICAL REVIEW X 9, 031052 (2019)

### [Non-patent Literature 3]

Yasuyuki Narita, et al., "Multiple Tin-Vacancy Centers in Diamond with Nearly Identical Photon Frequency and Linewidth", PHYSICAL REVIEW APPLIED 19, 024061 (2023)

### Summary of Invention

### Technical Problem

In the conventional techniques (Patent Literature 1 and Non-patent Literatures 1 to 3), for example, the temperature of a material (diamond) is gradually raised to a high temperature of not lower than 1000°C, and a heat treatment for a relatively long time is performed. For example, a color center(s) is/are generated in the material by raising the temperature of the material to not lower than 1000°C over a period of 10 minutes to several hours and holding this temperature for about several hours.

However, the inventors studied a method for producing a color center material (method for generating a color center(s)) and found out that it would be difficult to say that the conditions for the heat treatment are necessarily appropriate in the conventional techniques as described above. That is, as a result of various experiments, it was revealed that since the formation of a color center(s) proceeds more rapidly than generally assumed, it is preferable to make a rapid transition to a temperature condition suitable for the formation of a color center(s).

An object of an aspect of the present invention is to realize a method for generating a group IV-vacancy center(s), the method achieving the formation of a group IV-vacancy center(s) under more appropriate temperature conditions.

### Solution to Problem

To solve the above problem, a generation method in accordance with an aspect of the present invention is a method for generating a group IV-vacancy center(s), the method including: a preparation step of preparing a diamond containing a group IV element(s) and vacancies; and a rapid thermal annealing step of subjecting the diamond to rapid thermal annealing at a target temperature of not lower than 800°C to form a group IV-vacancy center(s) in the diamond.

### Advantageous Effects of Invention

According to an aspect of the present invention, rapid thermal annealing facilitates rapid transition to an appropriate temperature condition and progress of the formation of a group IV-vacancy center(s) under the appropriate temperature condition.

### Brief Description of Drawings

Fig. 1 is a flowchart illustrating an example of a production method in accordance with Embodiment 1 of the present invention.
Fig. 2 is a schematic diagram illustrating a state in which a group IV element(s) and vacancies are introduced into a diamond.
Fig. 3 is a graph showing an example of a rapid thermal annealing step.
Fig. 4 is a schematic diagram illustrating a structure of a group IV-vacancy center.
Fig. 5 is a schematic diagram illustrating a state in which a group IV-vacancy center(s) is formed in a diamond.
Fig. 6 is a flowchart illustrating an example of a production method in accordance with Embodiment 2 of the present invention.
Fig. 7 is a diagram illustrating maximum values of light emission intensities of samples before and after acid cleaning.
Fig. 8 is a diagram illustrating repetitions of heat treatment, PL measurement, and acid cleaning.
Fig. 9 is a photograph of HPHT synthetic diamond crystals that were subjected to a heat treatment under normal pressure.
Fig. 10 is a photograph of CVD synthetic diamond crystals that were subjected to a heat treatment under normal pressure.
Fig. 11 is a photograph of HPHT synthetic diamond crystals that were subjected to a heat treatment under high pressure.
Fig. 12 is a photograph of CVD synthetic diamond crystals that were subjected to a heat treatment under high pressure.
Fig. 13 is a diagram illustrating light emission spectra in PL measurement of the HPHT synthetic diamond crystals.
Fig. 14 is a diagram illustrating light emission spectra in PL measurement of synthetic diamond crystals.
Fig. 15 is a graph showing a relationship between a heat treatment time and a light emission intensity in synthetic diamond crystals prepared by an HPHT method.
Fig. 16 is a diagram illustrating a relationship between a heat treatment time and a light emission intensity in synthetic diamond crystals.
Fig. 17 is a diagram illustrating light emission spectra in PL measurement.
Fig. 18 is a diagram illustrating maximum values of light emission intensities of samples.
Fig. 19 is a diagram illustrating light emission spectra in PL measurement.
Fig. 20 is a diagram illustrating maximum values of light emission intensities of samples.
Fig. 21 is a diagram illustrating a relationship between a position on a sample and a maximum value of a light emission intensity.

### Description of Embodiments

### [Embodiment 1]

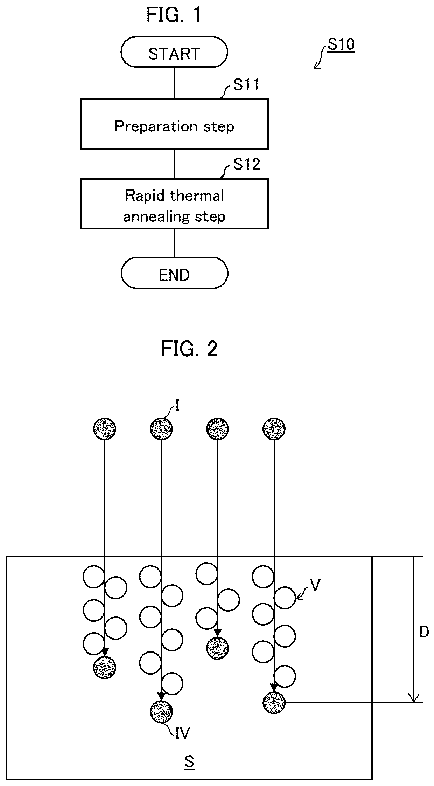

The following will describe an embodiment of the present invention in detail. Fig. 1 is a flowchart illustrating an example of a method S10 for producing a color center material (a method for generating a color center(s)) in accordance with Embodiment 1 of the present invention.

Here, a method for producing a diamond crystal having a group IV-vacancy center(s) (a method for generating a group IV-vacancy center(s)) will be described. As illustrated in Fig. 1, the production method (generation method) S10 includes a preparation step (S11) and a rapid thermal annealing step (S12).

### (1) Preparation step S11

The preparation step S11 is a step of preparing a diamond containing a group IV element(s) and vacancies. As will be described later, a group IV element(s) and vacancies can be introduced into a diamond by implantation of ions of the group IV element(s). Note that the vacancies may be formed by electron beam irradiation.

The diamond is, for example, a synthetic diamond, and is, as an example, a bulk (plate form) of a single crystal of a synthetic diamond or particles (powder form) thereof. The synthetic diamond can be produced by, for example, a high-pressure and high-temperature method (HPHT method), a chemical vapor deposition method (CVD method), or a detonation method. As the synthetic diamond, for example, a bulk of about several millimeters to powder-form particles having a diameter of about 5 nm to a diameter of about 200 nm can be used.

It is desired that the diamond basically do not contain nitrogen. This is because nitrogen is bonded to a vacancy to form an NV center, and consumes vacancies necessary for the formation of a group IV-vacancy center(s). However, the diamond is allowed to contain nitrogen to a certain extent. As shown in Example 1 which will be described later, it is possible to form the group IV-vacancy center(s), provided that the amount of nitrogen contained in the diamond is about the same (for example, about 1 ppm) as the implantation amount (for example, 5 ppm) of the group IV element(s).

The group IV element(s) is/are, for example, silicon (Si), germanium (Ge), or tin (Sn). The vacancy refers to a state in which carbon to be present in a crystal lattice of a diamond is missing. For example, by carrying out a next introduction step, it is possible to introduce the group IV element(s) and the vacancies into the diamond.

The preparation step S11 may include an introduction step of introducing a group IV element(s) and vacancies into a diamond by implanting group IV ions into the diamond.

As has already been described, the vacancies can also be formed by irradiation of the diamond with an electron beam. For example, by irradiating a diamond containing a group IV element(s) with an electron beam, a diamond containing a group IV element(s) and vacancies can be formed. The diamond containing the group IV element(s) can be formed by, for example, implantation of group IV ions into a diamond. That is, by implanting group IV ions into a diamond and irradiating the diamond with an electron beam, a group IV element(s) and vacancies can be introduced into the diamond. At this time, either of the implantation of group IV ions and the irradiation with an electron beam may be performed in any order or may be performed simultaneously.

Fig. 2 is a schematic diagram illustrating a state in which a group IV element(s) and vacancies are introduced into a diamond. By ionizing a group IV element(s) IV (group IV ions I) and performing acceleration by an electric field or the like, the group IV ions I can be implanted into a material (diamond S). By the implantation of the group IV ions I, the group IV element(s) IV and vacancies V can be introduced into the diamond S. The vacancies V are formed on a path along which the group IV ion I has traveled through the diamond S, and the group IV element(s) IV is implanted at an end point of the path. An implantation depth D at this time is preferably equal to or greater than a certain extent (as an example, the order of micrometers). This is because there is a possibility that the surface of the diamond may be altered to a non-diamond layer during the annealing step.

### (2) Rapid thermal annealing step S12

The rapid thermal annealing step S12 is a step of subjecting the diamond to rapid thermal annealing (RTA) at a target temperature of not lower than 800°C to form a group IV-vacancy center(s) in the diamond. As will be described later, by rapidly raising the temperature of the diamond, the group IV-vacancy center(s) can be formed at an appropriate target temperature. **If** the temperature of the diamond is raised at a slow rate, there is a possibility that the formation of the group IV-vacancy center(s) proceeds during the temperature rise, and the formation of the group IV-vacancy center(s) is substantially completed before the target temperature is reached.

In the rapid thermal annealing step S12, a heat treatment furnace capable of performing rapid thermal annealing can be used. Examples of such a heat treatment furnace include a heat treatment furnace capable of rapidly heating a sample (for example, a bulk and particles of a diamond) by irradiating, with light of high intensity (for example, infrared light or laser light) from a light source, a stage on which the sample is placed in the furnace. The stage is heated by the light source, whereby the sample on the stage is heated. As the light source, an infrared lamp or a laser light source can be used. Examples of the heat treatment furnace include an infrared lamp heating device (a heat treatment furnace using an infrared lamp as the light source).

For example, the rapid thermal annealing step S12 can be carried out in a heat treatment furnace in an atmosphere of inert gas (for example, argon gas) under normal pressure. Note, however, that the rapid thermal annealing step S12 may be carried out under high pressure of about 6 GPa to 10 GPa instead of normal pressure.

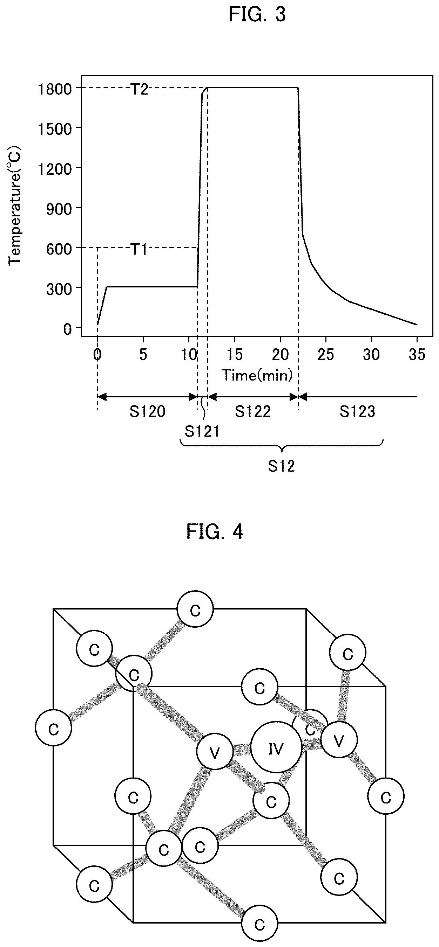

Fig. 3 is a graph showing an example of the rapid thermal annealing step S12. The rapid thermal annealing step S12 includes a rapid thermal process (rapid thermal processing; RTP) S121, a heat treatment step S122, and a temperature lowering step S123. Here, a preliminary heating step S120 is carried out before the rapid thermal annealing step S12.

That is, the preliminary heating step S120 may be carried out between the preparation step S11 and the rapid thermal annealing step S12. For example, this preliminary heating step S120 is a heat treatment step of holding the diamond in a temperature range of 200°C to 400°C (for example, 300°C) in order to remove moisture and the like that may be included in a bulk and particles (powder) of the diamond and in the heat treatment furnace. Since the group IV-vacancy center(s) is substantially not formed in the temperature range of the preliminary heating step S120, rapid thermal annealing is not necessarily used in the preliminary heating step S120.

In the rapid thermal process S121, the temperature of the diamond is rapidly raised by, for example, irradiating the stage on which the diamond is placed with light of high intensity from the light source. More specifically, in the rapid thermal process S121, the temperature of the diamond is rapidly raised to a high temperature (target temperature) of not lower than 800°C by irradiating the stage on which the bulk and particles of the diamond are placed with light of high intensity from the light source.

The rapid thermal process S121 preferably includes a step of raising the temperature of the diamond to a target temperature T2, the step being a step of raising the temperature of the diamond at a temperature rise rate At of not lower than 1000°C per minute from a temperature T1, which exceeds at least 600°C, to the target temperature T2, which is not lower than 800°C. By increasing the temperature rise rate At, it is possible to reduce the generation of a group IV-vacancy center(s) before the target temperature T2 is reached. The target temperature T2 is roughly in the range of 800°C to, for example, 1800°C or 2500°C, and is preferably varied depending on the type of group IV element as described later.

The temperature rise rate of not lower than ΔT°C per second is set in the range from the temperature T1 to the target temperature T2 of not lower than 800°C. This is because the group IV-vacancy center(s) is/are formed in this temperature range. Conversely speaking, at temperatures lower than this temperature range, the temperature rise rate does not need to be so high. Passing through this temperature range rapidly makes it easy to form a group IV-vacancy center(s) having good characteristics by an appropriate heat treatment at the set target temperature T2. If the temperature rise rate is low in this temperature range, there is a possibility that the formation of the group IV-vacancy center(s) proceeds before the target temperature T2 is reached and thus renders the set target temperature meaningless.

In the above description, the temperature rise rate At from the temperature T1 to the target temperature T2 is focused on. However, instead of the temperature rise rate At, or in addition to the temperature rise rate At, a temperature rise rate At0 from the temperature T1 to a temperature (T2 - ΔT) which is lower than the target temperature T2 by a predetermined value ΔT may be specified. For example, the temperature may be raised at a temperature rise rate of not lower than 1000°C per minute to the temperature (T2 - ΔT) which is lower by ΔT than the target temperature T2. As ΔT, for example, 50°C can be specified. Note that the temperature ΔT can be set to avoid the temperature of the sample from temporarily exceeding and falling below the target temperature (overshoot and undershoot).

Immediately before the target temperature T2 is reached, the amount of light irradiation from the light source is reduced. As a result, the rapid thermal annealing step S12 proceeds from the rapid thermal process S121 in which the temperature rapidly rises to the heat treatment step S122 in which the temperature is substantially fixed to the target temperature. In the heat treatment step S122, a group IV-vacancy center(s) having good characteristics is formed by an appropriate heat treatment at the set target temperature T2.

Fig. 4 is a schematic diagram illustrating a structure of a group IV-vacancy center. A lattice in which carbon C is missing is a vacancy V. The group IV-vacancy center(s) is composed of two vacancies V and a group IV element(s) IV that is disposed between the two vacancies V.

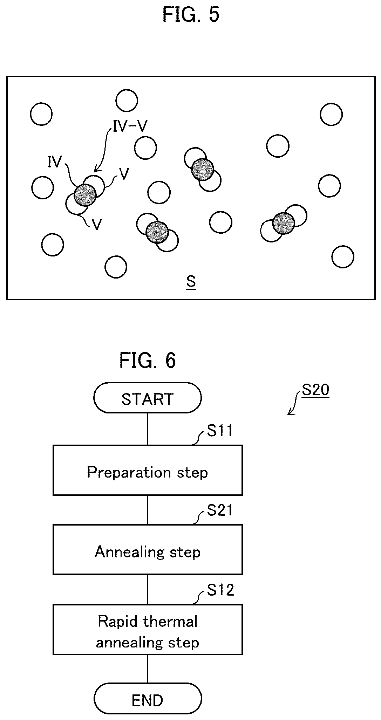

Fig. 5 is a schematic diagram illustrating a state in which a group IV-vacancy center(s) is formed in a diamond. By a heat treatment, the vacancies V and the group IV element(s) IV move. In particular, the vacancies V move at a high speed since the mass of the carbon C serving as a source of the vacancy V is smaller than the mass of the group IV element(s) IV (for example, silicon). Thus, the vacancies V and the group IV element(s) IV move and thereby form the group IV-vacancy center(s).

For example, as has already been described, the target temperature T2 is roughly in the range of 800°C to 1800°C or in the range of 800°C to 2500°C. The target temperature T2 can be set to 1800°C for silicon (Si), germanium (Ge), and tin (Sn). In this case, a time (heat treatment time) of the heat treatment step S122 can be set to a range of 1 minute to 50 minutes, 5 to 50 minutes, and 100 minutes or longer for silicon (Si), germanium (Ge), and tin (Sn), respectively.

After the heat treatment step S122, the irradiation of the stage on which the diamond is placed with the light from the light source is stopped, and the temperature of the diamond lowers to a temperature close to room temperature (temperature lowering step S123). The diamond having the group IV-vacancy center(s) is taken out from the heat treatment furnace and can be used in a variety of applications.

As described above, in the present embodiment, rapid thermal annealing enables rapid transition to an appropriate temperature condition (target temperature) and reliable progress of the formation of the group IV-vacancy center(s) at the target temperature.

### [Embodiment 2]

The following will describe another embodiment of the present invention. For convenience of description, members having functions identical to those described in Embodiment 1 are assigned identical referential numerals, and their descriptions are omitted here.

Fig. 6 is a flowchart illustrating an example of a production method (generation method) S20 in accordance with Embodiment 2 of the present invention. As illustrated in Fig. 6, in the present embodiment, an annealing step S21 is carried out between the preparation step S11 and the rapid thermal annealing step S12.

The annealing step S21 is a step of treating the diamond at a temperature of not lower than 600°C and lower than 800°C to form a divacancy(ies) (Di-Vacancy: V₂) in the diamond. For example, the diamond is held at a target temperature in the range of 600°C to 750°C for 10 hours to 100 hours. In the annealing step S21, vacancies disposed in a dispersed manner in the diamond move to form a divacancy(ies) (V₂).

Like the rapid thermal annealing step S12, the annealing step S21 can be carried out, for example, in an atmosphere of inert gas (for example, argon gas) under normal pressure or under high pressure of about 6 GPa to 10 GPa.

In addition, the annealing step S21 and the rapid thermal annealing step S12 may be sequentially carried out using a heat treatment furnace (for example, an infrared lamp heating device) that is capable of performing rapid thermal annealing.

After the annealing step S21, by carrying out the rapid thermal annealing step S12, a group IV-vacancy center(s) is formed in the diamond.

Carrying out the annealing step S21 makes it possible to increase the generation amount of the group IV-vacancy center(s) as compared with the case where the annealing step S21 is not carried out. It is considered that, in the annealing step S21, the divacancy(ies) (V₂) serving as a precursor of the group IV-vacancy center(s) is formed, whereby the group IV-vacancy center(s) is formed more efficiently.

Note that, after the annealing step S21, it is not preferable to carry out a normal heat treatment in which the temperature rise rate At to the target temperature T2 is relatively low, instead of the rapid thermal annealing step S12. In the normal heat treatment, there is a possibility that the divacancy(ies) (V₂) generated in the annealing step S21 may be decomposed and return to normal vacancies.

As described above, in the present embodiment, before the rapid thermal annealing step S12, the annealing step S21 is carried out to form the divacancy(ies) (V₂), thereby enabling more efficient formation of the group IV-vacancy center(s).

### [Summary]

A generation method according to Aspect 1 of the present invention is a method for generating a group IV-vacancy center(s), said method including: a preparation step of preparing a diamond containing a group IV element(s) and vacancies; and a rapid thermal annealing step of subjecting the diamond to rapid thermal annealing at a target temperature of not lower than 800°C to form a group IV-vacancy center(s) in the diamond.

The generation method according to Aspect 2 of the present invention is configured such that, in Aspect 1, the generation method further includes, between the preparation step and the rapid thermal annealing step, an annealing step of treating the diamond at a temperature of not lower than 600°C and lower than 750°C to form a divacancy(ies) (Di-Vacancy: V₂) in the diamond, wherein in the rapid thermal annealing step, the group IV-vacancy center(s) is formed from the divacancy(ies).

The generation method according to Aspect 3 of the present invention is configured such that, in Aspect 1 or 2, the rapid thermal annealing step includes a step of raising a temperature of the diamond to the target temperature of not lower than 800°C, the step being a step of raising the temperature of the diamond at a temperature rise rate of not lower than 1000°C per minute from a temperature exceeding at least 600°C to the target temperature.

The generation method according to Aspect 4 of the present invention is configured such that, in any of Aspects 1 to 3, the preparation step includes an introduction step of introducing the group IV element(s) and the vacancies into the diamond by implanting group IV ions into the diamond.

The generation method according to Aspect 5 of the present invention is configured such that, in any of Aspects 1 to 3, the preparation step includes an introduction step of introducing the group IV element(s) and the vacancies into the diamond by implanting group IV ions into the diamond and irradiating the diamond with an electron beam.

The generation method according to Aspect 6 of the present invention is configured such that, in any of Aspects 1 to 5, the group IV element(s) is/are Si, and, in the rapid thermal annealing step, the diamond is held at a target temperature of about 1800°C for not less than 1 minute and less than 50 minutes.

The generation method according to Aspect 7 of the present invention is configured such that, in any of Aspects 1 to 5, the group IV element(s) is/are Ge, and, in the rapid thermal annealing step, the diamond is held at a target temperature of about 1800°C for not less than 5 minutes and less than 50 minutes.

The generation method according to Aspect 8 of the present invention is configured such that, in any of Aspects 1 to 5, the group IV element(s) is/are Sn, and, in the rapid thermal annealing step, the diamond is held at a target temperature of about 1800°C for not less than 100 minutes.

A production method according to Aspect 9 of the present invention is a method for producing a diamond crystal having a group IV-vacancy center(s), the method including: a preparation step of preparing a diamond containing a group IV element(s) and vacancies; and a rapid thermal annealing step of subjecting the diamond to rapid thermal annealing at a target temperature of not lower than 800°C to form a group IV-vacancy center(s) in the diamond.

The present invention is not limited to the embodiments, but can be altered by a skilled person in the art within the scope of the claims. The present invention also encompasses, in its technical scope, any embodiment derived by combining technical means disclosed in differing embodiments.

### Example 1

Example 1 corresponding to Embodiment 1 will be described below. As a sample, crystals of synthetic diamonds prepared by a high-pressure and high-temperature method (HPHT method) and a chemical vapor deposition method (CVD method) were used. The synthetic diamond prepared by the HPHT method contains nitrogen of approximately 1 ppm. On the other hand, the synthetic diamond prepared by the CVD method contains nitrogen of approximately not more than 1 ppb (1/1000 of 1 ppm). In terms of the amount of nitrogen impurities, the concentrations are different.

### (1) Preparation step S11

Silicon (Si), germanium (Ge), and tin (Sn) were each ionized, accelerated to 18 MeV by an accelerator, and irradiated onto this sample. As a result, silicon and the like were each implanted to a depth of 3 µm at a concentration of 5 ppm.

### (2) Rapid thermal annealing step S12

Thereafter, the preliminary heating step S120 and the rapid thermal annealing step S12 (the rapid thermal process S121, the heat treatment step S122, and the temperature lowering step S123) were carried out in an infrared lamp heating device in an atmosphere of argon gas under normal pressure. In the rapid thermal process S121, the temperature of the sample reached 1800°C in a temperature rise time of 1 minute. In the heat treatment step S122, the temperature was set to 1800°C, and a treatment time was changed in the range of 1 minute to 10 minutes.

More specifically, in the preliminary heating step S120, the temperature was raised from room temperature to 300°C in 1 minute and held at 300°C for 10 minutes. In the rapid thermal process S121, the temperature was raised from 300°C to 1750°C in 30 seconds, and the temperature was raised to 1800°C in 30 seconds. In the heat treatment step S122, a heat treatment was carried out at a temperature of 1800°C while the temperature of 1800°C was held for 1 minute to 10 minutes.

After the rapid thermal annealing step S12, the sample was subjected to photoluminescence (PL) measurement to determine the generation amount of a color center(s) in the sample. In the PL measurement, a microlaser Raman spectroscopic measurement device LabRAM HR Evolution manufactured by Horiba, Ltd. was used, and the measurement was carried out with a 532 nm laser (CW). Thereafter, the sample was cleaned with acid (Acid). With respect to the sample, the heat treatment (the preliminary heating step S120, the rapid thermal annealing step S12), the PL measurement, and the acid cleaning were repeated.

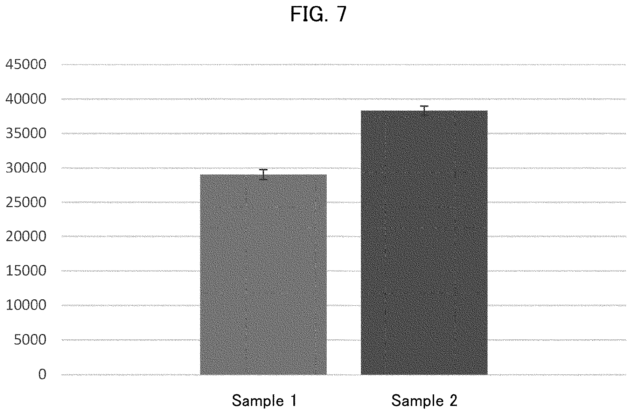

Fig. 7 is a diagram illustrating maximum values of light emission intensities of samples 1 and 2 before and after the acid cleaning. Sample 1 was subjected to the rapid thermal annealing step S12 (RTA) at 1800°C for 100 minutes. Sample 2 was subjected to the acid cleaning after the RTA at 1800°C for 100 minutes. That is, the difference between samples 1 and 2 is whether or not the acid cleaning was carried out. A comparison between the PL intensities of samples 1 and 2 reveals that the PL intensity decreases if the acid cleaning is not carried out.

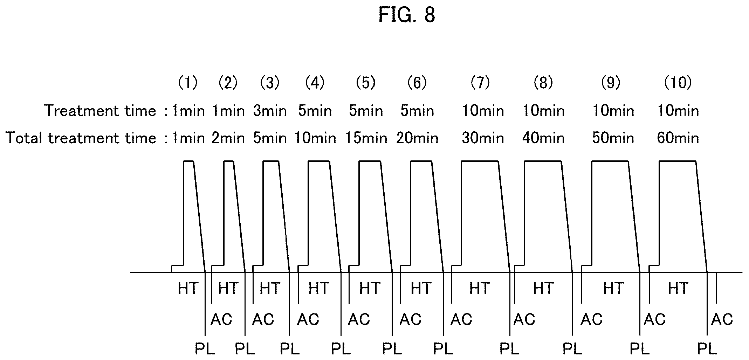

Fig. 8 is a diagram illustrating repetitions of heat treatment HT, PL measurement PL, and acid cleaning AC. As illustrated in Fig. 7, the process goes on for ten iterations. Heat treatment times in the 1st to 10th iterations are 1 minute, 1 minute, 3 minutes, 5 minutes, 5 minutes, 5 minutes, 10 minutes, 10 minutes, 10 minutes, and 10 minutes, respectively, and cumulative heat treatment times are 1 minute, 2 minutes, 5 minutes, 10 minutes, 15 minutes, 20 minutes, 30 minutes, 40 minutes, 50 minutes, and 60 minutes. As a result, a relationship between the heat treatment time and the generation amount of a color center(s) is shown.

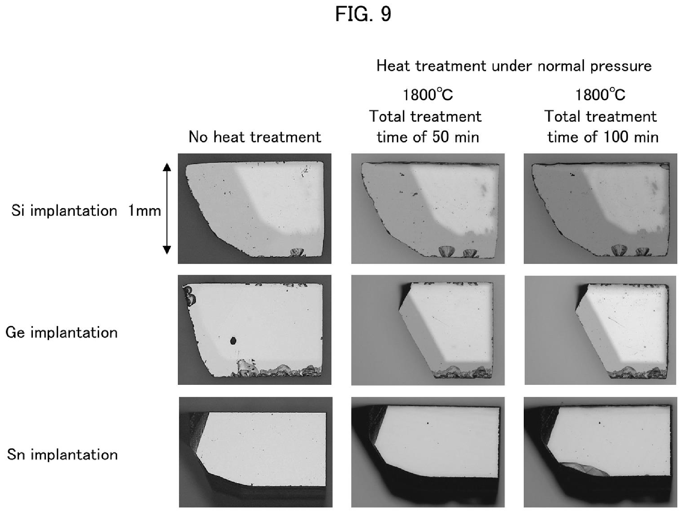

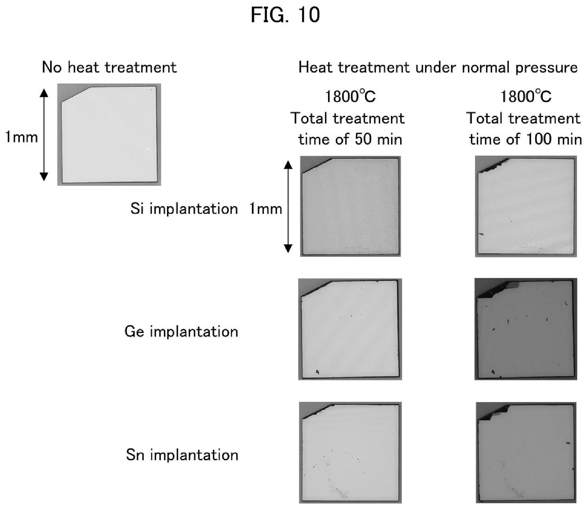

Figs. 9 and 10 show photographs of synthetic diamond crystals that were prepared by an HPHT method and a CVD method, respectively, and that were subjected to a heat treatment under normal pressure. Samples into which silicon (Si), germanium (Ge), and tin (Sn) had been respectively implanted were treated under the following conditions (1) and (2), and photographed by a bright field microscope after acid cleaning.
(1) No heat treatment
(2) Heat treatment at 1800°C under normal pressure (cumulative heat treatment time: 50 minutes and 100 minutes)

Note that, in Fig. 10, regarding the samples subjected to no heat treatment, only a photograph of one typical sample is shown. This is because the synthetic diamond crystals prepared by the CVD method are subjected to polishing and laser cutting so as to have a predetermined shape, and thus the samples subjected to no heat treatment have the same appearance in the microscope photographs.

As shown in Figs. 9 and 10, the surface shapes of the samples were not changed by the heat treatment (at 1800°C for 100 minutes) under normal pressure.

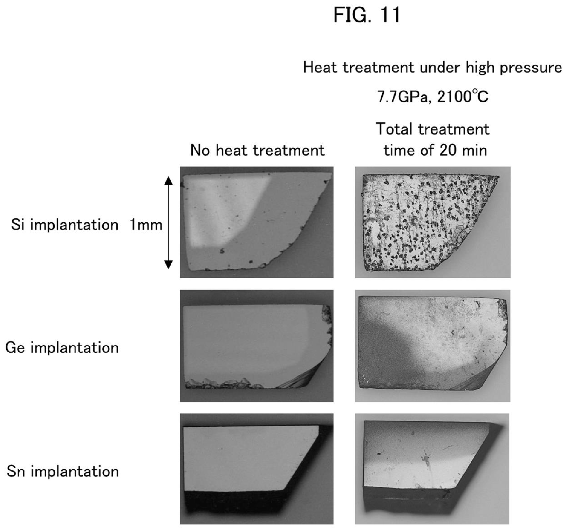

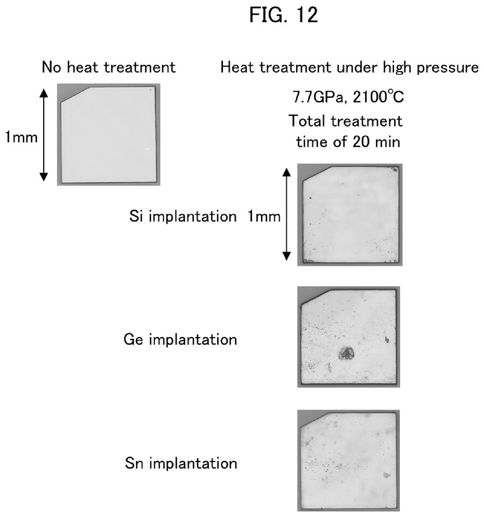

Figs. 11 and 12 show photographs of synthetic diamond crystals that were prepared by the HPHT method and the CVD method, respectively, and that were subjected to a heat treatment under high pressure. Samples into which silicon (Si), germanium (Ge), and tin (Sn) had been respectively implanted were treated under the following conditions (1) and (2), and photographed by a bright field microscope after acid cleaning.
(1) No heat treatment
(2) Heat treatment at 2100°C under high pressure (cumulative heat treatment time: 20 minutes)

Here, the temperature rise to 300°C and the holding of 300°C in the preliminary heating step S120 and the rapid temperature rise in the rapid thermal process S121 were not carried out.

Note that, in Fig. 12, regarding the samples subjected to no heat treatment, only a photograph of one typical sample is also shown for the same reason as in Fig. 10.

As shown in Figs. 11 and 12, the surface shapes of the samples were changed by the heat treatment (at 2100°C for 20 minutes) under high pressure (7.7 GPa).

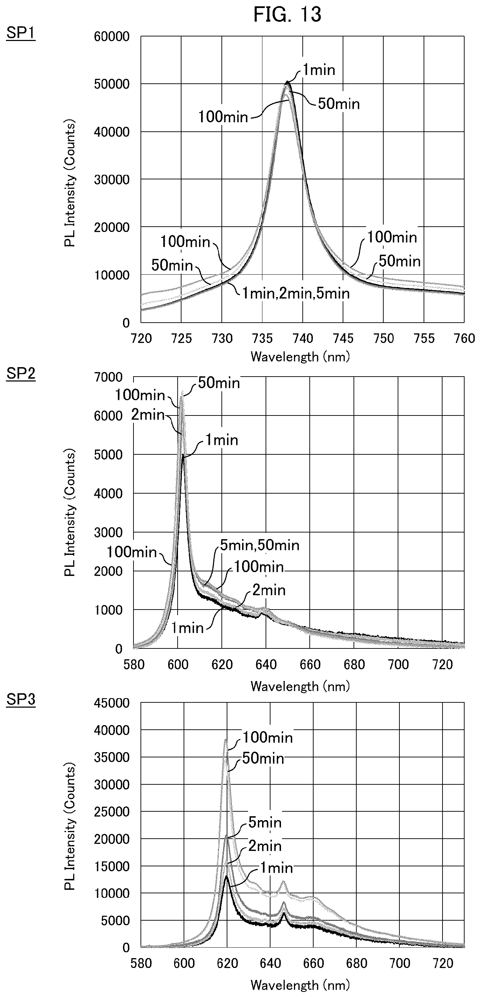

Fig. 13 is a diagram illustrating light emission spectra in the PL measurement of the HPHT synthetic diamond crystals. SP1, SP2, and SP3 indicate PL spectra from the samples into which silicon (Si), germanium (Ge), and tin (Sn) were implanted, respectively.

As illustrated in Fig. 13, zero-phonon lines (ZPLs) specific to a Si-V center(s), a Ge-V center(s), and a Sn-V center(s) appear at wavelengths of 738 nm, 602 nm, and 619 nm, respectively. This reveals that the Si-V center(s), the Ge-V center(s), and the Sn-V center(s) are formed by the rapid thermal annealing step S12 and the annealing step S21. It can be said that the higher the intensity of the PL spectrum, the higher the concentration of each color center and the higher the generation rate.

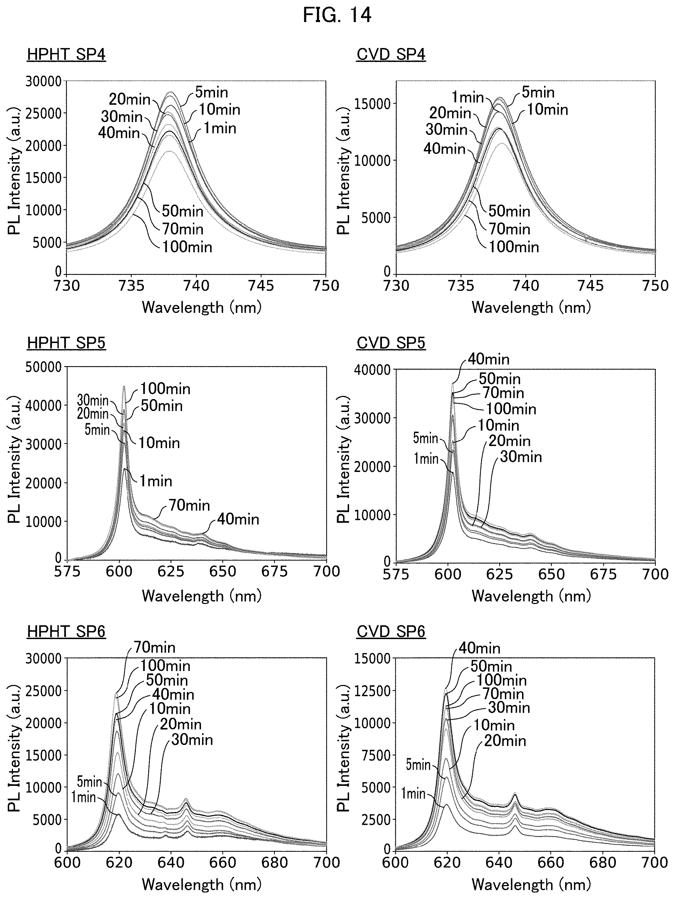

Fig. 14 is a diagram illustrating light emission spectra in the PL measurement of the synthetic diamond crystals. The left column and the right column correspond to the synthetic diamond crystals prepared by the HPHT method and the CVD method, respectively. SP4, SP5, and SP6 correspond to the samples into which silicon (Si), germanium (Ge), and tin (Sn) were implanted, respectively. Varying heat treatment times were set to 1 minute, 5 minutes, 10 minutes, 20 minutes, 30 minutes, 40 minutes, 50 minutes, 70 minutes, and 100 minutes. Note that the same conditions for the PL measurement of the samples were set for the synthetic diamond crystals prepared by the HPHT method and the CVD method.

From Fig. 14, it can be seen that there is a certain degree of difference in the intensity of the PL spectra between the synthetic diamond crystals prepared by the HPHT method and the synthetic diamond crystals prepared by the CVD method, but there is almost no difference in the shape of the PL spectra therebetween.

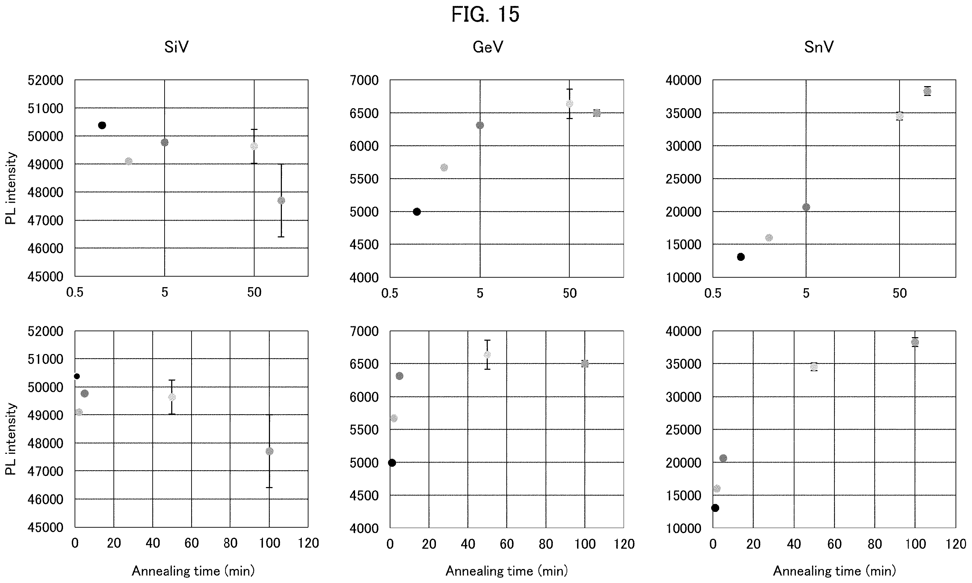

Fig. 15 is a graph showing a relationship between the heat treatment time and the light emission intensity. Here, an HPHT synthetic diamond crystal was used as a sample, and the light emission intensity of the PL spectrum (hereinafter also referred to as "PL intensity") was measured. SiV, GeV, and SnV respectively indicate relationships between the PL intensities at the ZPLs of the Si-V center(s), Ge-V center(s), and Sn-V center(s) and the heat treatment times. The time axes of the upper and lower diagrams in Fig. 15 are logarithmic and linear, respectively.

As shown in Fig. 15, it can be said that heat treatments for about 1 minute, about 50 minutes, and about 100 minutes or more are effective for the Si-V center(s), the Ge-V center(s), and the Sn-V center(s), respectively. As the mass number of Group IV ions increases, the heat treatment time at which the PL intensity reaches its maximum increases. With regard to SiV and GeV, the PL intensity became maximum and then decreased. In the heat treatment at 1800°C, it was found that, as the mass number of Group IV ions increases, the heat treatment time at which the PL intensity reaches its maximum increases.

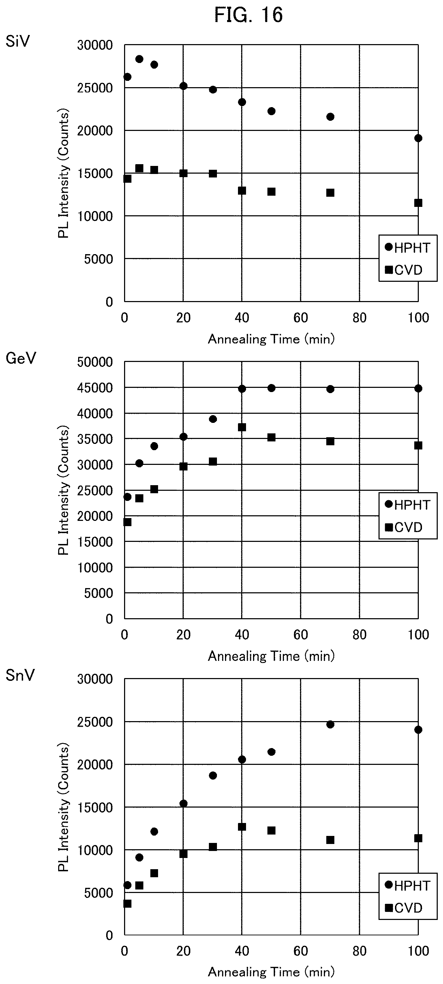

Fig. 16 is a diagram illustrating a relationship between the heat treatment time and the light emission intensity in the synthetic diamond crystals prepared by the HPHT method and the CVD method. The same conditions for the PL measurement of the samples were set for the synthetic diamond crystals prepared by the HPHT method and the CVD method.

From Fig. 16, it can be seen that the PL intensity of the HPHT synthetic diamond is higher than that of the CVD synthetic diamond.

### Example 2

Example 2 corresponding to Embodiment 2 will be described below. In Example 2, a crystal of a synthetic diamond prepared by the CVD method was used as a sample. This synthetic diamond contains nitrogen of approximately not more than 1 ppb. In addition, in Example 2, an experiment in which CVD (bulk) containing nitrogen of 8 ppm was used as a sample was also performed in order to measure a state in which vacancies decrease. Since the preparation step is the same as that of Example 1, detailed description thereof will be omitted.

In Example 2, before the rapid thermal annealing step S12, the annealing step S21 at 600°C for 100 hours was carried out to form a divacancy(ies) (Di-Vacancy: V₂), which is a precursor of a group IV-vacancy center(s). Thereafter, the rapid thermal annealing step S12 including the heat treatment step S122 at 1800°C for 1 minute was carried out (sample a). Similarly, after the annealing step S21 at 600°C for 10 hours was carried out to form a divacancy(ies) (Di-Vacancy: V₂), the rapid thermal annealing step S12 including the heat treatment step S122 at 1800°C for 1 minute was carried out (sample b).

For comparison, sample c was also prepared by carrying out the rapid thermal annealing step S12 (including the heat treatment step S122 at 1800°C for 1 minute) without carrying out the annealing step S21.

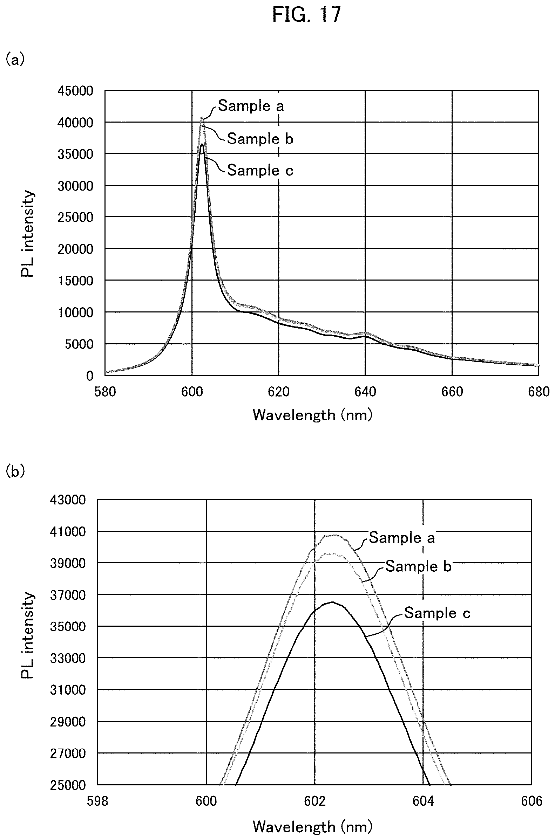

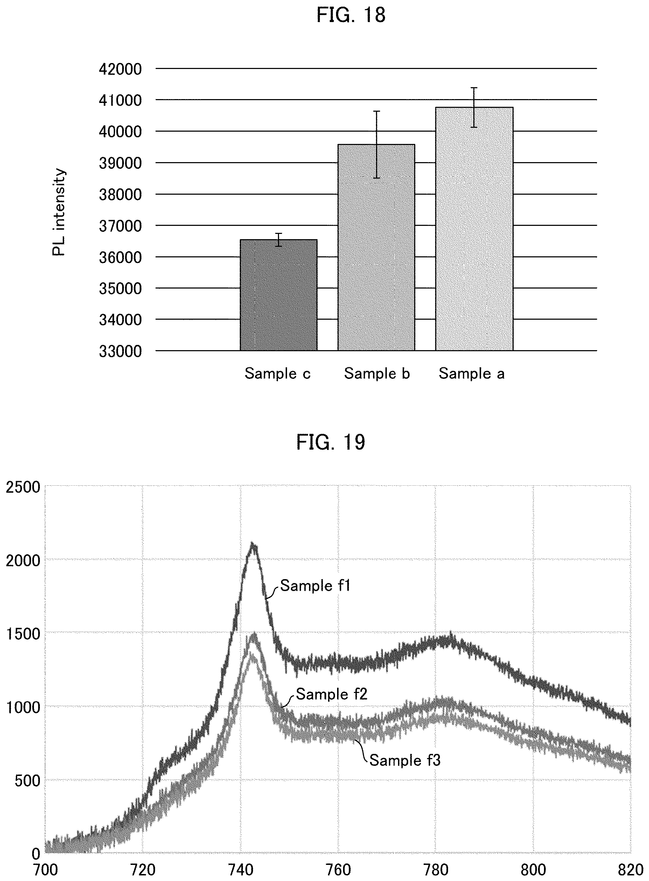

Fig. 17 is a diagram illustrating light emission spectra of the samples a and b prepared by carrying out the annealing step S21 and the sample c prepared without carrying out the annealing step S21. (a) and (b) of Fig. 17 are an overall view of the light emission spectra and a partially enlarged view thereof, respectively. Fig. 18 is a diagram illustrating light emission intensities of the samples a, b, and c at ZPLs. As illustrated in Fig. 17, the generation amount of the group IV-V center(s) is increased by carrying out the annealing step S21 to form the divacancy(ies) (V₂).

In Example 2, the divacancy(ies) is formed by the annealing step S21 at 600°C. Since the divacancy(ies) is formed by two vacancies that bind together, it should be observed that the vacancies reduce after the annealing step S21. As a sample for a control experiment, a crystal of synthetic diamond prepared by the CVD method was used. This synthetic diamond contains nitrogen of approximately 8 ppm. Vacancies were formed in the sample by irradiating the sample with electron beams of 2 MeV and 10¹⁸ cm⁻². After the annealing step S21, the PL measurement was performed.

Fig. 19 is a diagram illustrating PL spectra. For sample f1, the annealing step S21 is not carried out. On the other hand, for sample f2, the annealing step S21 is carried out at 600°C for 10 hours. For sample f3, the annealing step S21 is carried out at 600°C for 100 hours.

As illustrated in Fig. 19, at a wavelength of 741 nm, a peak of a charge-neutral vacancy(ies) (GR1 center(s)) appears. The PL intensity of the GR1 center(s) decreases with an increase in the heat treatment time at 600°C (in the order of the samples f1, f2, and f3). From this tendency, it can be construed that annealing reduces GR1, and a divacancy(ies) is formed.

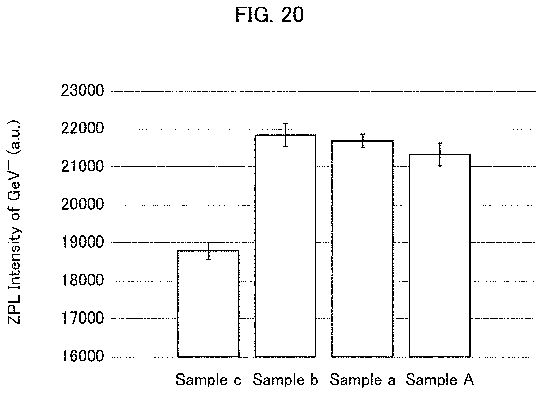

Fig. 20 is a diagram illustrating maximum values of the light emission intensities of samples a, b, c, and A. Here, for a reproducibility experiment, sample a, sample b, and sample c of Example 2 were prepared again. In addition to these samples a to c, the sample A was prepared under the following conditions. That is, after the annealing step S21 at 700°C for 100 hours was carried out to form a divacancy(ies) (Di-Vacancy: V₂), the rapid thermal annealing step S12 including the heat treatment step S122 at 1800°C for 1 minute was carried out to prepare sample A.

From Fig. 20, it can be seen that the generation amount of the group IV-V center(s) is increased by carrying out the annealing step S21 to form the divacancy(ies) (V₂).

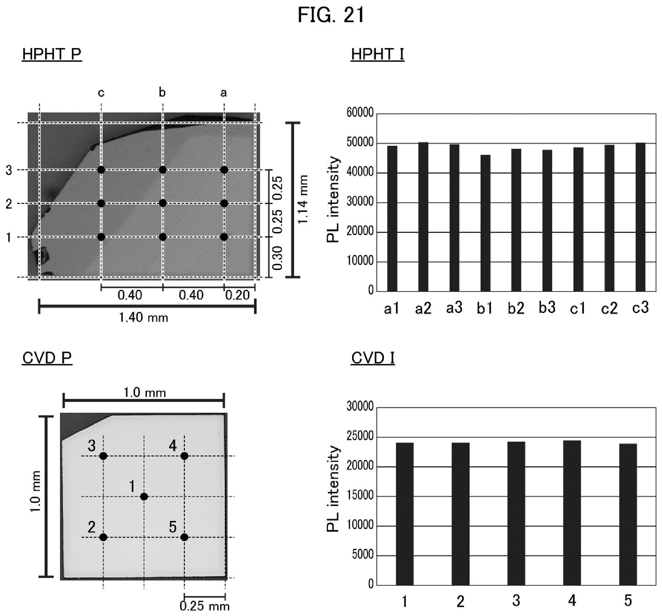

In order to examine the uniformity of impurities and growth sectors in each sample, the in-plane distribution of the Ge-V center concentration in the germanium-implanted sample which had been subjected to heat treatment at 1800°C for 50 minutes was measured. Fig. 21 is a diagram illustrating a relationship between a position on a sample and a maximum value of a light emission intensity. Fig. 21 includes four diagrams (diagrams HPHT_P and CVD_P on the left side and diagrams HPHT_I and CVD_I on the right side). The diagrams HPHT_P and CVD_P are diagrams (photographs) illustrating positions on the sample. The diagrams HPHT_I and CVD_I are graphs illustrating relationships between the positions (a1 to c3 and 1 to 5) on the sample and the PL intensity. As the sample, synthetic diamond crystals prepared by the HPHT method and the CVD method were used. The former and the latter each contained nitrogen of about 1 ppm and nitrogen of less than 1 ppb, respectively.

From the diagrams HPHT_I and CVD_I, it can be seen that the PL intensity of the HPHT synthetic diamond varies depending on the measurement position, whereas the PL intensity of the CVD synthetic diamond is substantially constant regardless of the measurement position. This difference is considered to be caused by the concentration distribution of impurities such as nitrogen as follows.

That is, in the HPHT synthetic diamond, (1) a nitrogen concentration is high since nitrogen is easily incorporated into the crystal in the synthesis process, and (2) the amount of nitrogen incorporated varies on a growth sector by growth sector basis. Since a part of nitrogen serves as an NV center(s), PL emission by the NV center(s) can occur. The spectrum of this PL emission is superimposed on the PL spectrum of the group IV-vacancy center(s). As a result of this, it is considered that the PL intensity of the HPHT synthetic diamond varies by reflecting the concentration distribution of nitrogen (variations in nitrogen concentration due to the measurement position). In contrast, in the CVD synthetic diamond, the concentration of impurities such as nitrogen is uniform and low, and it is thus considered that substantially no PL emission caused by the NV center(s) occurs, and only the PL emission of the group IV-vacancy center(s) is measured.

### Reference Signs List

S11: preparation step
S12: rapid thermal annealing step
S120: preliminary heating step
S121: rapid thermal process
S122: heat treatment step
S123: temperature lowering step
S21: annealing step

## Claims

1. A method for generating a group IV-vacancy center(s), said method comprising:
a preparation step of preparing a diamond containing a group IV element(s) and vacancies; and
a rapid thermal annealing step of subjecting the diamond to rapid thermal annealing at a target temperature of not lower than 800°C to form a group IV-vacancy center(s) in the diamond.

2. The method according to claim 1, further comprising, between the preparation step and the rapid thermal annealing step,
an annealing step of treating the diamond at a temperature of not lower than 600°C and lower than 750°C to form a divacancy(ies) (Di-Vacancy: V₂) in the diamond, wherein
in the rapid thermal annealing step, the group IV-vacancy center(s) is formed from the divacancy(ies).

3. The method according to claim 1 or 2, wherein
the rapid thermal annealing step includes a step of raising a temperature of the diamond to the target temperature of not lower than 800°C, the step being a step of raising the temperature of the diamond at a temperature rise rate of not lower than 1000°C per minute from a temperature exceeding at least 600°C to the target temperature.

4. The method according to any one of claims 1 to 3, wherein the preparation step includes an introduction step of introducing the group IV element(s) and the vacancies into the diamond by implanting group IV ions into the diamond.

5. The method according to any one of claims 1 to 3, wherein the preparation step includes an introduction step of introducing the group IV element(s) and the vacancies into the diamond by implanting group IV ions into the diamond and irradiating the diamond with an electron beam.

6. The method according to any one of claims 1 to 5, wherein
the group IV element(s) is/are Si, and
in the rapid thermal annealing step, the diamond is held at a target temperature of around 1800°C for not less than 1 minute and less than 50 minutes.

7. The method according to any one of claims 1 to 5, wherein
the group IV element(s) is/are Ge, and
in the rapid thermal annealing step, the diamond is held at a target temperature of around 1800°C for not less than 5 minutes and less than 50 minutes.

8. The method according to any one of claims 1 to 5, wherein
the group IV element(s) is/are Sn, and
in the rapid thermal annealing step, the diamond is held at a target temperature of around 1800°C for not less than 100 minutes.

9. A method for producing a diamond crystal having a group IV-vacancy center(s), said method comprising:
a preparation step of preparing a diamond containing a group IV element(s) and vacancies; and
a rapid thermal annealing step of subjecting the diamond to rapid thermal annealing at a target temperature of not lower than 800°C to form a group IV-vacancy center(s) in the diamond.
